# EUROPÄISCHE PATENTSCHRIFT

(11) **EP 1 903 124 B1**
(45) Veröffentlichungstag und Bekanntmachung des Hinweises auf die Patenterteilung: **24.10.2012**
(21) Anmeldenummer: 07016319.1
(22) Anmeldetag: 21.08.2007
(51) Int. Cl.: C23C 18/12, C23C 16/453, C23C 4/02, C23C 4/10, C23C 16/40

(54) **Verfahren zur Herstellung einer anorganisch-anorganischen Gradientenkompositschicht**
Method for manufacturing an inorganic-inorganic gradient composite coating
Procédé de fabrication d'une couche composite à gradient inorganique-inorganique

(30) Priorität: 22.09.2006 DE 102006045617
(43) Veröffentlichungstag der Anmeldung: 26.03.2008
(73) Patentinhaber: Innovent e.V. Technologieentwicklung, 07745 Jena (DE)
(72) Erfinder: Tiller, Hans-Jürgen, 07749 Jena (DE)
(74) Vertreter: Donath, Dirk

(56) Entgegenhaltungen:
- EP-A- 0 792 846
- WO-A-97/05302
- DE-A1- 2 812 116
- DE-A1- 3 844 522
- DE-A1- 10 163 646
- DE-A1-102004 053 706
- US-A1- 2002 034 885
- US-A1- 2005 249 901
- TILLER H-J ET AL: "A NEW CONCEPT OF METAL-RESIN ADHESION USING AN INTERMEDIATE LAYER OF SIOX-C" THIN SOLID FILMS, ELSEVIER-SEQUOIA S.A. LAUSANNE, CH, Bd. 169, Nr. 1, 1. Februar 1989 (1989-02-01), Seiten 159-168, XP000052009 ISSN: 0040-6090
- BAHLAWANE ET AL: "Systematic microstructural investigation of alumina deposited by liquid fuel combustion chemical vapor deposition" SURFACE AND COATINGS TECHNOLOGY, ELSEVIER, AMSTERDAM, NL, Bd. 200, Nr. 12-13, 31. März 2006 (2006-03-31), Seiten 4097-4103, XP024995573 ISSN: 0257-8972 [gefunden am 2006-03-31]

## Beschreibung

Die Erfindung betrifft ein Verfahren zur Herstellung einer anorganisch-anorganischen Gradientenkompositschicht.

Sowohl organische, wie auch anorganische Schichtsysteme werden als Permeationssperren gegenüber Gasen, Ionen und Materialaidditiven beschrieben. Die Wirkung ist sehr stark abhängig von der Struktur der Schicht, bezogen auf die Moleküle denen gegenüber eine Sperrwirkung erzielt werden soll. Anorganische Schichten erreichen bei optimaler Gestaltung eine wesentlich höhere Wirksamkeit als organische Systeme. So lassen sich beispielsweise mit 10 bis 20 nm dicken SiO₂-Schichten auf Polymerfolien OTR Werte (cm³ / m² * Atm * d) erreichen.

Die Herstellung solcher Schichten erfolgt derzeit über Gasphasenverfahren, bevorzugt über Vakuum- und Plasmatechniken [siehe hierzu bspw. H.-Ch. Langowski: Galvanotechnik, 11/2003, 2800 - 2807; T. Hachisuka et. al.: Technical Conference Proceedings, Society of Vacuum Coaters (2005), 48th, 634 - 637, US 20050249901].

Der Nachteil dieser Verfahren besteht in der teuren Verfahrenstechnik (Vakuumanlagen) oder aber in den thermischen Belastungen der Substrate im Herstellungsprozess und den damit verbunden Aufwendungen.

Aus diesen Gründen gibt es eine Reihe von Versuchen nasschemischer Verfahrenstechniken zur Herstellung von Barriereschichten zur Anwendung zu bringen [siehe hierzu H.-Ch. Langowski: Galvanotechnik, 11/2003, 2800 - 2807]. Die Barrierewirkung wird dabei sowohl gegenüber Gasen, als auch Ionen (insbesondere Natrium) gesehen. Häufig lässt sich gleichzeitig mit der Barrierewirkung eine Korrosionsschutzwirkung verbinden und durch den Einbau funktioneller organischer Gruppen auch eine weitergehende Funktionalisierung der Schichten, wie beispielsweise Hydrophilierung oder Hydrophobierung, erreichen.

Eine weitere Eigenschaftsmodifikation ist durch die Verwendung anorganischer Füllstoffe in der anorganischen Matrix möglich. Dabei stellen die Farbgestaltung und die optischen Eigenschaften der Schichten eine Form der Funktionalisierung dar.

Ein Nachteil der nasschemisch aufgetragenen Schichtsysteme ist ihre mangelnde Duktilität und - bedingt durch die unterschiedlichen thermischen Ausdehnungskoeffizienten - gegenüber organischen, beziehungsweise polymeren Substraten hervorgerufene Spannung in der Grenzfläche. Das führt zu einer Steigerung des Bruchverhaltens bei mechanischer Beanspruchung und damit zu einer erheblichen Verschlechterung der Permeationseigenschaften.

Die Schrift von H.-J. Tiller, R. Göpel und B. Magnus "A new concept of metal-resin adhesion using an intermediate layer of SiOx-C" in Thin Solid Films, ELSERVIER-SEQUOIA S.A. LAUSANNE, CH, Bd. 169, Nr.1, 1. Febraur 1989, Seiten 159- 168 offenbart ein Verfahren zur Herstellung eines anorganisch-anorganischen Vielschichtverbundsystems (Gradientenverbundschicht), bei dem in einem ersten Schritt auf einem Substrat mit Hilfe einer Flamme eine erste mikroporöse anorganische Schicht (SiOₓ-C- Schicht) mit einem Porositätsgradienten zur Oberfläche hin erzeugt wird und in einem zweiten Schritt darauf eine Flüssigkeit, die eine zweite anorganische Schicht (Silan- Kopplungs-Agenz) bildet und die erste Schicht penetriert, aufgebracht wird.

Aus DE 28 12 116 A1 ist bekannt, dass Wasserglas, Kieselsol oder Silazan als Flüssigkeit zum Ausbilden einer anorganisch anorganischen Gradientenverbundschicht auf einer porösen Aluminiumschicht verwendet wird.

Die Aufgabe der Erfindung besteht darin ein Verfahren zur Herstellung einer weiteren anorganisch-anorganischen Gradientenkompositschicht anzugeben, das die zuvor stehend genannten Nachteile des Standes der Technik vermeidet.

Gelöst wind close Aufgabe durch das Verfahren nach Patentanspruch 1.

Bevorzugte Ausführungsarten sind in den Patentansprüchen 2-11 angegeben.

Überraschenderweise zeigte es sich, das mit Hilfe einer anorganisch-anorganischen Kompositgradientenschicht in der Grenzfläche zwischen Substrat und anorganischen Schicht eine deutliche Verbesserung der Permeationseigenschaften in Richtung der Permeation von Gasen, als auch von Ionen und damit auch in den Korrosionsschutzeigenschaften zu erreichen ist.

Die anorganisch-anorganische Gradientenkompositschicht wird erfindungsgemäß dadurch erreicht, dass auf ein Substrat in einem ersten Schritt, mit Hilfe einer Flamme eine mikroporöse anorganische Schicht mit einem Porositätsgradienten zur Oberfläche der Schicht hin gebildet wird und in einem zweiten Schritt auf diese Schicht eine Flüssigkeit, die eine anorganische Schicht bildet und die mikroporöse, mit Hilfe der Flamme aufgetragenen Schicht penetriert und auf diese Weise eine anorganisch-anorganisch Gradientenkompositschicht bildet.

Dabei wird auf ein Substrat eine mikro-, beziehungsweise nanoporöse anorganische Schicht im Dickenbereich von 2 nm bis 2 µm, bevorzugt 10 nm bis 200 nm aufgetragen. Diese Schicht besitzt einen Porositätsgradienten, der zur Oberfläche hin zunimmt.

Auf diese Schicht wird eine Flüssigkeit, die eine anorganische Struktur ausbildet, aufgetragen. Sie penetriert die mikro-, beziehungsweise nanoporöse Schicht und bildet auf diese Weise eine Gradientenkompositschicht aus.

Zur Herstellung der mikro- oder nanoporösen Schicht lassen sich aus dem Stand der Technik bekannte Verfahren, insbesondere flammengestützte CCVD Verfahren, benutzen [siehe hierzu bspw. US 4,600,390; US 4,620,988; DD 253 259; DD 256 151; DE 100 19 926 sowie R. Musil, H.-J. Tiller, "Der Kunststoff-Metall-Verbund", Hüthig-Verlag, Heidelberg 1989; H.-J. Tiller, et. al., "Thin Solid Films" 169 (1989) 159 - 168].

Die Gradientenkompositschicht weist dabei eine Dicke von 5 nm bis 100 µm, bevorzugt zwischen 30 nm und 1 µm, auf.

Die mit der Flamme hergestellte anorganische Schicht weist eine mikroporöse Partikelstruktur zwischen 2 nm und 10 µm, bevorzugt 5 nm und 100 nm, auf.

Als mikro- oder nanoporöse Schicht lassen sich eine Vielzahl bekannter anorganischer Komponenten, bevorzugt Metalloxide, wie insbesondere SiOₓ, Al₂O₃, ZrOₓ, TOi₂, SnOₓ oder ZnO allein oder in Mischung verwenden [siehe hierzu bspw. US 5,652,021; US 5,858,465].

Die mikroporöse anorganische Schicht kann auch aus einem Schwermetalloxid, bevorzugt CrOₓ, PbO, FeOₓ, NiOₓ, WOₓ, MoOₓ, VOₓ, oder auch aus Ag bzw. AgOₓ bestehen.

Die mikroporösen anorganischen Schichten können auch aus Mischungen der o.g. Stoffe bestehen.

Den anorganischen Komponenten kann ein anorganischer oder organischer Füllstoff zugesetzt sein.

Bei dem Füllstoff handelt es sich bevorzugt um Korrosionsinhibitoren, farbbildende Pigmente oder Schichtsilikate.

Die CCVD-Technologie bietet hierfür ein breites Spektrum an Möglichkeiten. So lassen sich durch Variationen der Precursorverbindungen eine Vielzahl von Verbindungen in die Flamme einbringen und an der Oberfläche zu anorganischen Schichten umsetzten, als auch in Kombination mit der Flamme an die Oberfläche bringen [siehe hierzu DE 103 28 436.2].

Die mögliche Ausbildung mikroporöser Strukturen bei derartigen Verfahren wurde mehrfach beschrieben [siehe hierzu bspw. H.-J. Tiller, et. al., "Thin Solid Films" 169 (1989) 159 - 168] und zur Verbesserung der Haftung organischer Schichten auf unterschiedlichsten Substraten eingesetzt und beschrieben [H.-J. Tiller, et. al., GLAS + RAHMEN, Verlagsanstalt Handwerk GmbH Düsseldorf, K 42236, 1996; H.-J. Tiller, et. al., JOT, 36 - 38, 07/1997; H.-J. Tiller, et. al., GLAS + RAHMEN, Verlagsanstalt Handwerk GmbH Düsseldorf, 02/1999; H.-J. Tiller, et. al., JOT, 08/2002]. Bevorzugt wurde in diesen Fällen auf SiO₂, beziehungsweise SiOₓ als schichtbildende Komponente zurückgegriffen. In vielen Fällen ist dafür die zusätzliche Anwendung eines Haftvermittlers, der die Anbindung der organischen Schicht an die anorganische Schicht ermöglicht, nötig. Im Falle von Silikonverbindungen als organische Beschichtung kann in vielen Fällen auf die Verwendung eines Haftvermittlers verzichtet werden [siehe hierzu bspw. H.-J. Tiller, et. al., 9. Internationale Symposium Swissbonding, Rapperswil, CH, 1995; Ph. Müller, DE 10 2005 035 443 A1].

Als anorganische flüssige Beschichtungen lassen sich die bekannten anorganischen Systeme der Sol-Gel-Chemie, Wasserglas, Kieselsol oder auch SiO₂-bildende Silazane einsetzten. Um die Duklitität der verwendeten Schichten zu erhöhen ist der Zusatz organischer Komponenten, der gleichzeitig auch das Aushärteverhalten, sowie die Funktionalität der Schichen verändern kann, zweckmäßig.

Als solche Zusätze können funktionalisierte Alkoxysilane, wie beispielsweise Mono- oder Dimethylalkoxysilane, aber auch Aminoalkoxysilane, wie beispielsweise γ-amino-Propyl-Trialkoxysilan dienen. Die funktionalisierten Alkoxysilane können auch in Mischung untereinander und mit Tetraalkoxysilanen oder chlorierten Silanen eingesetzt werden. Eine Netzwerkmodifizierung der Wassergläser ist auch durch unfunktionalisierte Tetraalkoxy- oder partiell chlorierte Silane möglich.

Ein vergleichbarer Weg der Funktionalisierung lässt sich mit Kieselsolen realisieren. Die Modifizierung sowohl von Wassergläsern, als auch von Kieselsolen mit Alkoxysilanen ist Stand der Technik und erfordert die Berücksichtigung einer Reihe weiterer Randbedingungen, wie beispielsweise pH-Wert Einstellung, Einhaltung von Präparationsbedingungen, wie zum Beispiel Temperatur, Durchmischung u. A..

An Stelle von Siliziumverbindungen ist auch der Zusatz von Titan- und Zirkonverbindungen möglich und bekannt.

Die Duktilität und das Aushärteverhalten sowie die Schichteigenschaften können durch den Zusatz polymerer oder netzwerkbildender organischer Verbindungen bewirkt werden. Als solche sind beispielsweise Polyvenylalkohole unterschiedlichster Molmasseverteilung und Funktionalisierung sowie Cellulose und Cellulosederivate bekannt. Ein vergleichbarer Effekt lässt sich auch mit Sacchariden unterschiedlichster Strukturfunktionalität erreichen.

Erfindungsgemäβ werden Zucker-Zelluloxe oder/und Stärkevervindung zugenetzt.

### 1. Ausführungsbeispiel

Erhöhung der Barierrewirkung einer PET-Folie nach Beschichtung mit einer Kompositgradientenschicht. Eine 12 µm dicke PET-Folie wurde vergleichsweise, hinsichtlich ihrer Sauersoffpermeation, ohne Beschichtung mit einer mikroporösen SiOₓ-Schicht (20 nm), einer Natriumwasserglasschicht (20 µm-Rakel) und einer mikroporösen SiOₓ /Wasserglas-Kompositgradientenschicht (20 nm, nanoporöse SiOₓ + Wasserglas mit einem 20 µm-Rakel aufgetragen) beschichtet. Die Präparationsbedingungen waren im Einzelnen folgende:
- mikroporöse SiOₓ-Schicht:
   Propanluftflamme mit 2,5 % TMS (Tetramethylsilan), bezogen auf das Brenngas, dotiert.
   Brennerbreite: 10 cm
   Durchlaufgeschwindigkeit: 3 Durchläufe, 12 m / Minute Leistungsdichte: 0,5 kW / cm
   Brennerabstand: 5 cm
   Folientemperierung: 50 °C
- Natriumwasserglasschicht:
   Aufgerakelt mit 20 µm-Rakel. Aushärtung der Schicht: 2 Stunden bei 60°C. Effektive Restschichtdicke ca. 1 µm. (Siehe Tabelle 1)

### 2. Ausführungsbeispiel

Erhöhung der Barierrewirkung einer PET-Folie nach Beschichtung mit einer Kompositgradientenschicht. Eine 25 µm dicke Polypropelen-Folie wurde vergleichsweise, hinsichtlich ihrer Sauerstoffpermeation, ohne Beschichtung mit einer mikroporösen SiOₓ-Schicht (20 nm), einer Natriumwasserglasschicht (20 µm-Rakel) und einer mikroporöse SiOₓ /Wasserglas-Kompositgradientenschicht (20 nm, nanoporöse SiOₓ + Wasserglas mit einem 20 µm-Rakel aufgetragen) beschichtet. Die Präparationsbedingungen waren im Einzelnen folgende:
- mikroporöse SiOₓ-Schicht:
   Propanluftflamme mit 2,5 % TMS (Tetramethylsilan), bezogen auf das Brenngas, dotiert.
   Brennerbreite: 10 cm
   Durchlaufgeschwindigkeit: 3 Durchläufe, 12 m / Minute Leistungsdichte: 0,5 kW / cm
   Brennerabstand: 5 cm
   Folientemperierung: 25 °C
- Natriumwasserglasschicht:
   Aufgerakelt mit 20 µm-Rakel. Aushärtung der Schicht: 2 Stunden bei 60 °C. Effektive Restschichtdicke ca. 1 µm. (siehe Tabelle 2)

### 3. Ausführungsbeispiel

Korrosionsschutz von Stahlblech (St38) durch eine Gradientenkompositbeschichtung, mikroporöse SiOₓ + Polysilazan. Präparationsbedingungen:
Auftrag der mikroporösen SiOₓ-Schicht:
   Propan / Sauerstoffbrenner 10 cm Breite, Silandosierung bezogen auf Brenngas 1,5 %.
   Durchlaufgeschwindigkeit: 2 Durchläufe, 3 m / Minute
   Leistungsdichte: 0,5 kW / cm
   Brennerabstand: 8 cm

Der Polysilazanauftrag erfolgt durch tauchen in unterschiedlich konzetrierten Silazanlösungen mit den Schichtdicken d₀, d₀/2, d₀/4, d₀/8.

Die Korrosionsschutzwirkung erfolgte durch Sichtbewertung der Fläche und eines, auf die Oberfläche, aufgetragenen Andreaskreuzes. Die Korrosionsschutzwirkung wurde mit der Bewertung - (schlecht) bis + (ohne Beanstandung) durchgeführt. Die Belastung erfolgte durch Lagerung der Proben, 60 Minuten bei 80 °C in Wasser (nicht destilliert). (siehe Tabelle 3)

### 4. Ausführungsbeispiel

Vergleichsweise zu Ausführungsbeispiel 3 wurden polierte Aluminiumbleche unter gleichen Bedingungen wie Ausführungsbeispiel 3 vorbehandelt und einem 48-Stunden Belastungstest in 10 %-iger NaCl, bei 96 °C gelagert. Ohne Kompositgradientenschicht mit mikroporöser SiOₓ- oder reiner Polysilazanbeschichtung waren die Proben nach weniger als 6 Stunden korrodiert. Mit Kompositgradientenschicht waren die Proben auch nach 48 Stunden ohne Beanstandungen.

**Tabelle 1**

| | **OTR-Wert** |
|---|---|
| **Folienpräparation** | **Sauerstoff in cm³ /m²d bar** |
| **·** 12 *µ*m-Rakel PET-Folie (ohne Beschichtung) | 120 |
| **·** mikroporöse SiOₓ-Schicht auf 12 µm PET-Folie | 30 |
| **·** Wasserglas auf 12 *µ*m PET-Folie | 50 bis 120 (je nach Benetzungszustand) |
| **·** mikroporöses SiOₓ + Wasserglas (Kompositgradientenschicht) | 0,2 bis 0,5 |

**Tabelle 2**

| | **OTR-Wert** |
|---|---|
| **Folienpräparation** | **Sauerstoff in cm³ / m²d bar** |
| **·** 12 *µ*m-Rakel PET-Folie (ohne Beschichtung) | 2000 |
| **·** mikroporöse SiOₓ-Schicht auf 25 µm Polypropelen-Folie | 150 |
| **·** Wasserglas auf 25 µm Polypropelen-Folie | 200 bis 2000 (je nach Benetzungszustand) |
| **·** mikroporöses SiOₓ + Wasserglas (Kompositgradientenschicht) | 0,3 bis 0,5 |

**Tabelle 3**

| **Oberflächenpräparation** | **Bewertung der Korrosion** | | | | |
|---|---|---|---|---|---|
| **·** ohne Beschichtung | - | | | | |
| **·** mikroporöse SiOₓ-Beschichtung | (-) | | | | |
| **·** Polysilazanbeschichtung | | (+) | (-) | - | - |
| **·** mikroporöse SiOₓ + Polysilazanbeschichtung | | + | + | + | (+) |
| | | d₀ | d₀/2 | d₀/4 | d₀/8 |

## Patentansprüche

1. Verfahren zur Herstellung einer anorganisch-anorganischen Gradientenverbundschicht, bei dem in einem ersten Schritt auf einem Substrat mit Hilfe einer Flamme eine erste mikroporöse anorganische Schicht in Form von Metalloxid als eine Partikelstruktur mit einem Porositätsgradienten zur Oberfläche hin erzeugt wird und in einem zweiten Schritt darauf eine Flüssigkeit, die eine zweite anorganische Schicht bildet und die erste Schicht penetriert, aufgebracht wird, dadurch gekenntzeichnet, dass die erste Schicht im Dickenbereich von 2 nm bis 2 µm mit einer mikroporösen Partikelstruktur zwischen 2 nm und 10 µm aufgetragen und als Flüssigkeit Wasserglas, Kieselsol oder Silazan verwendet wird, so dass eine Gradientenverbundschicht mit einer Dicke zwischen 5 nm bis 100 µm ausgebildet wird, wobei der Flüssigkeit ein funktionalisiertes Silan sowie eine Zucker-, Zellulose- oder/und Stärkeverbindüng zugesetzt wird.

2. Verfahren gemäß Anspruch 1, **dadurch gekennzeichnet, dass** das funktionalisierte Silan ein Alkoxisilan ist.

3. Verfahren gemäß Anspruch 1 **dadurch gekennzeichnet, dass** das Metalloxid aus SiOₓ, Al₂O₃, TiOₓ, ZrOₓ, ZnO, SnO₂ oder einer Mischung dieser besteht.

4. Verfahren gemäß Anspruch 1 **dadurch gekennzeichnet, dass** das Metall aus CrOₓ, PbO, FeOₓ, NiOₓ, WOₓ, MoOₓ, VO_{x,}, AgOₓ oder einer Mischung dieser besteht.

5. Verfahren gemäß Anspruch 1 **dadurch gekennzeichnet, dass** die Flamme ein Gemisch aus einem organischen Brenngases und Luft oder Sauerstoff oder mit Sauerstoff angereicherter Luft enthält.

6. Verfahren gemäß Anspruch 5 **dadurch gekennzeichnet, dass** das Brenngas Propan, Butan oder Acetylen ist.

7. Verfahren gemäß Anspruch 1 **dadurch gekennzeichnet, dass** die Flamme aus einem Gemisch von Wasserstoff und Sauerstoff oder einem dieses Gemisch enthaltenden Trägergas besteht.

8. Verfahren nach Anspruch 5, 6 oder 7 **dadurch gekennzeichnet, dass** dem Brenngas eine, das Metalloxid bildende anorganische Verbindung als Precursorsubstanz zugesetzt wird.

9. Verfahren nach Anspruch 5, 6 oder 7 **dadurch gekennzeichnet, dass** dem Sauerstoff oder Luft-Sauerstoffgemisch oder der Luft eine, das Metalloxid bildende anorganische Verbindung als Precursorsubstanz zugesetzt wird.

10. Verfahren nach Anspruch 5, 6 oder 7 **dadurch gekennzeichnet, dass** dem Gemisch aus Brenngas und Sauerstoff oder sauerstoffhaltiger Luft oder Luft eine, das Metalloxid bildende anorganische Verbindung als Precursorsubstanz zugesetzt wird.

11. Verfahren nach Anspruch 8, **dadurch gekennzeichnet, dass** die Precursorsubstanz der Brenngasflamme in flüssiger Form zugesetzt wird.

## Claims

1. Method for manufacturing an inorganic-inorganic gradient composite coating in which, in a first step, a first microporous inorganic coating in form of metal oxide is produced by means of a flame on a substrate towards the surface, said metal oxide has a particle structure with a porosity gradient, and in a second step, a liquid, which forms a second inorganic coating and penetrates the first coating, is applied on said first coating, wherein the first coating with a thickness in the range from 2 nm to 2 µm having a microporous particle structure with a thickness of between 2 nm and 10 µm is applied and sodium silicate, silica sol or silazane is used as a liquid so that a gradient composite coating with a thickness in the range from 5 nm to 100 µm is formed, and an functionalized silane as well as a sugar, cellulose or/and a starch compound is added to the liquid.

2. Method according to claim 1, wherein the functionalized silane is an alkoxysilane.

3. Method according to claim 1, wherein the metal oxide consists of SiOₓ, Al₂O₃, TiOₓ, ZrOₓ, ZnO, SnO₂ or a mixture of these compounds.

4. Method according to claim 1, wherein the metal consists of CrOₓ, PbO, FeOₓ, NiOₓ, WOₓ, MoOₓ, VO_{x,}, AgOₓ or a mixture of these compounds.

5. Method according to claim 1, wherein the flame consists of a mixture of an organic fuel gas and air or oxygen or air enriched with oxygen.

6. Method according to claim 5, wherein the fuel gas is propane, butane or acetylene.

7. Method according to claim 1, wherein the flame consists of a mixture of hydrogen and oxygen or of a carrier gas containing this mixture.

8. Method according to claim 5, 6 or 7, wherein an inorganic compound forming the metal oxide is added as a precursor substance to the fuel gas.

9. Method according to claim 5, 6 or 7, wherein an inorganic compound forming the metal oxide is added as a precursor substance to the oxygen or air-oxygen mixture or air.

10. Method according to claim 5, 6 or 7, wherein an inorganic compound forming the metal oxide is added as a precursor substance to the mixture of fuel gas and oxygen or oxygen-containing air or air.

11. Method according to claim 8, wherein the precursor substance is added in liquid state to the fuel gas flame.

## Revendications

1. Procédé pour la fabrication d'une couche composite inorganique-inorganique, pour lequel, dans un premier pas, une première couche inorganique microporeuse sous forme d'oxyde métallique est formée sur un substrat à l'aide d'une flamme comme structure de particules avec un gradient de porosité vers la surface et, dans un deuxième pas, un liquide est appliqué là-dessus qui forme une deuxième couche inorganique et qui pénètre dans la première couche, est **caractérisé en ce que** la première couche est appliquée dans la gamme d'épaisseur de 2 nm à 2 µm avec une structure de particules microporeuse entre 2 nm et 10 µm et que le verre soluble, la sole de silice ou la silazane est utilisé comme liquide de sorte qu'une couche composite à gradient soit formée avec une épaisseur entre 5 nm à 100 µm en ajoutant un silane fonctionnalisé ainsi qu'un composé de sucre, cellulose ou/et amidon au liquide.

2. Le procédé suivant la revendication 1 est **caractérisé en ce que** le silane fonctionnalisé est un alkoxysilane.

3. Le procédé suivant la revendication 1 est **caractérisé en ce que** l'oxyde métallique se compose de SiOₓ, Al₂O₃, TiOₓ, ZrOₓ, ZnO, SnO₂ ou d'un mélange d'eux.

4. Le procédé suivant la revendication 1 est **caractérisé en ce que** le métal se compose de CrOₓ, PbO, FeOₓ, NiOₓ, WOₓ, MoOx, VO_{x,}, AgOₓ ou d'un mélange d'eux.

5. Le procédé suivant la revendication 1 est **caractérisé en ce que** la flamme contient un mélange d'un gaz combustible organique et d'air ou d'oxygène ou d'air enrichi en oxygène.

6. Le procédé suivant la revendication 5 est **caractérisé en ce que** le gaz combustible est propane, butane ou acétylène.

7. Le procédé suivant la revendication 1 est **caractérisé en ce que** la flamme se compose d'un mélange d'hydrogène et oxygène ou d'un gaz porteur contenant ce mélange.

8. Le procédé suivant la revendication 5, 6 ou 7 est **caractérisé en ce qu'**un composé inorganique qui forme l'oxyde métallique est ajouté au gaz combustible comme substance précurseur.

9. Le procédé suivant la revendication 5, 6 ou 7 est **caractérisé en ce qu'**un composé inorganique qui forme l'oxyde métallique est ajouté à l'oxygène ou au mélange d'air-oxygène ou à l'air comme substance précurseur.

10. Le procédé suivant la revendication 5, 6 ou 7 est **caractérisé en ce qu'**un composé inorganique qui forme l'oxyde métallique est ajouté au mélange de gaz combustible et d'oxygène ou d'air oxygéné ou d'air comme substance précurseur.

11. Le procédé suivant la revendication 8 est **caractérisé en ce que** la substance précurseur est ajoutée à la flamme de gaz combustible sous forme liquide.
